# EUROPEAN PATENT SPECIFICATION

(11) **EP 4 312 325 B1**
(45) Date of publication and mention of the grant of the patent: **17.06.2026**
(21) Application number: 23188346.3
(22) Date of filing: 28.07.2023
(51) Int. Cl.: H01S 5/02255, H01S 5/00, H01S 5/02208, H01S 5/0222, H01S 5/0225, H01S 5/02251, H01S 5/0237, H01S 5/40, G02B 6/42

(54) **LIGHT-EMITTING DEVICE**
LICHTEMITTIERENDE VORRICHTUNG
DISPOSITIF ÉLECTROLUMINESCENT

(30) Priority: 29.07.2022 JP 2022122102
(43) Date of publication of application: 31.01.2024
(60) Divisional application: 26177643.9
(73) Proprietor: Nichia Corporation, Anan-shi, Tokushima 774-8601 (JP)
(72) Inventor: KOZURU, Kazuma, Anan-shi, 774-8601 (JP)
(74) Representative: Betten & Resch

(56) References cited:
- WO-A1-2016/051836
- WO-A1-2021/010488
- US-B1- 6 271 049
- US-B1- 6 422 766
- US-B2- 8 855 155

## Description

### CROSS-REFERENCE TO RELATED APPLICATION

This application claims priority to Japanese Patent Application No. 2022-122102, filed on July 29, 2022.

### BACKGROUND

The present disclosure relates to a light-emitting device.

In recent years, with an increase in output power of a semiconductor laser element, technology has been developed in which the semiconductor laser element is not used as an excitation light source but is used as a light source of a laser beam with which a material is directly irradiated to process the material. Such a technology is referred to as direct diode laser (DDL) technology.

The DDL technology uses a light-emitting module including a plurality of semiconductor laser elements. The light-emitting module combines a plurality of laser beams obtained from laser beams emitted from the plurality of semiconductor laser elements to emit a high-power laser beam. When traveling directions of the plurality of laser beams are aligned in the same direction as designed, the plurality of laser beams can be effectively combined. PCT Patent Publication No. WO 2016/051836 discloses an example of an optical component that can reduce deviation between a traveling direction of a laser beam emitted from a semiconductor laser element and a designed traveling direction.

The Patent document US6422766B1 discloses a light-emitting device comprising a plurality of deflective mirror members for transmission of a laser beam through a cover above a laser.

### SUMMARY

Provided is a light-emitting device capable of reducing deviation between a traveling direction of a laser beam emitted from a semiconductor laser element and a designed traveling direction.

The invention is defined by the independent claim.

According to certain embodiments of the present disclosure, a light-emitting device is provided that is capable of reducing deviation between a traveling direction of a laser beam emitted from a semiconductor laser element and a designed traveling direction.

### BRIEF DESCRIPTION OF DRAWINGS

FIG. 1A is a top view schematically illustrating a configuration of a light-emitting module according to an exemplary embodiment of the present disclosure.
FIG. 1B is a lateral side view schematically illustrating the configuration of the light-emitting module according to the exemplary embodiment of the present disclosure.
FIG. 1C is a lateral side view schematically illustrating the configuration of the light-emitting module according to the exemplary embodiment of the present disclosure.
FIG. 1D is a top view schematically illustrating a configuration of a modified example of a light-emitting module according to an embodiment of the present disclosure.
FIG. 2A is a perspective view schematically illustrating a configuration of a light-emitting device according to an exemplary embodiment of the present disclosure.
FIG. 2B is an exploded perspective view of the light-emitting device illustrated in FIG. 2A.
FIG. 2C is another exploded perspective view of the light-emitting device illustrated in FIG. 2A.
FIG. 2D is a perspective view of a frame body included in the light-emitting device illustrated in FIG. 2C viewed from below.
FIG. 2E is a top view of the configuration of the light-emitting device illustrated in FIG. 2A with a second mirror member and a cover omitted.
FIG. 2F is a cross-sectional view parallel to a YZ plane of the light-emitting device illustrated in FIG. 2A.
FIG. 3 is a diagram schematically illustrating a configuration of a DDL device according to an exemplary embodiment of the present disclosure.
FIG. 4A is an exploded perspective view of a laser light source.
FIG. 4B is a cross-sectional view parallel to the YZ plane of the laser light source.

### DETAILED DESCRIPTIONS

A light-emitting device according to an embodiment of the present disclosure and a light-emitting module including a plurality of the light-emitting devices will be described below in detail with reference to the drawings. The same reference numerals appearing in multiple drawings indicate the same or similar parts.

The embodiment described below is exemplified to embody a technical idea of the present invention, and the present disclosure is not limited to the following. Further, the descriptions of dimensions, materials, shapes, relative arrangements, and the like of components are not intended to limit the scope of the present invention thereto but intended to be illustrative. The size and positional relationship of members illustrated in the drawings may be exaggerated to facilitate understanding.

In the present description and the scope of claims, polygons such as triangles or quadrangles, including shapes in which the corners of the polygons are rounded, chamfered, beveled, or coved, are referred to as polygons. A shape obtained by processing not only the corners (ends of sides), but also an intermediate portion of a side is also referred to as a polygon. In other words, a shape partially processed while leaving a polygonal shape as a base is included in the interpretation of "polygon" described in the present description and the scope of claims.

### Embodiments

### Light-emitting Module

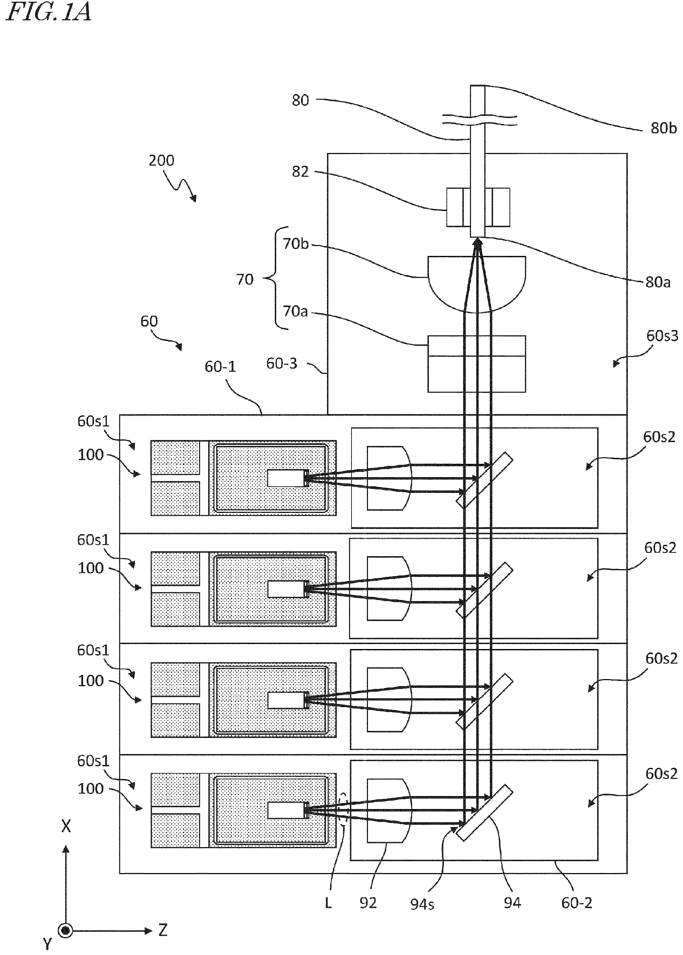

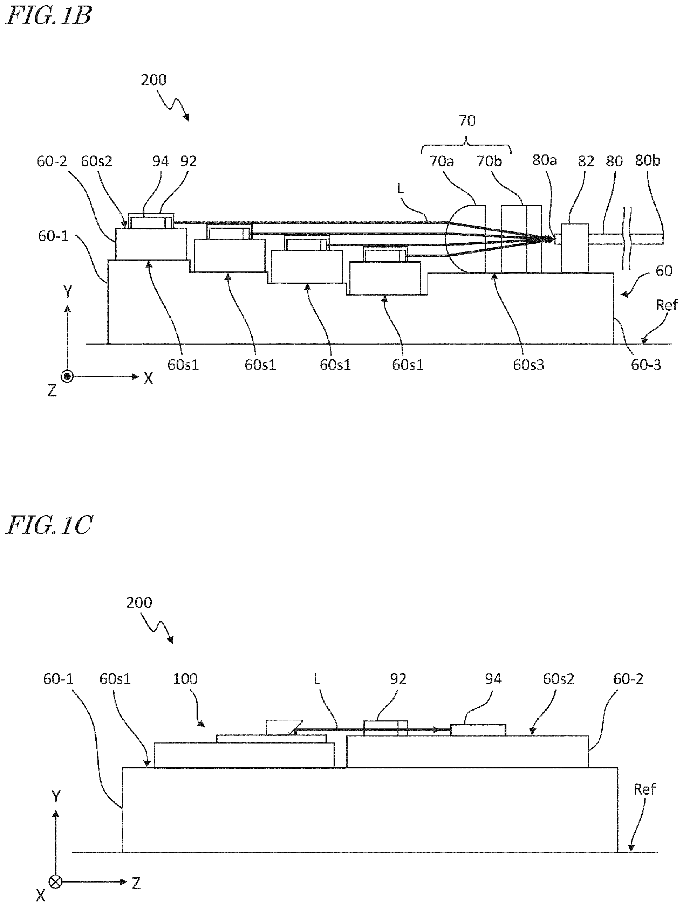

First, a configuration example of a light-emitting module according to an embodiment of the present disclosure will be described with reference to FIGS. 1A to 1C. FIG. 1A is a top view schematically illustrating the configuration of the light-emitting module according to the exemplary embodiment of the present disclosure. FIG. 1B is a lateral side view schematically illustrating the configuration of the light-emitting module according to the exemplary embodiment of the present disclosure. FIG. 1C is another lateral side view schematically illustrating the configuration of the light-emitting module according to the exemplary embodiment of the present disclosure. These drawings schematically illustrate an X-axis, a Y-axis, and a Z-axis that are orthogonal to one another for reference. The direction of an arrow on the X-axis is referred to as a +X direction, and an opposite direction thereof is referred to as a -X direction. When the ±X directions are not distinguished, the ±X directions are simply referred to as X directions. The same applies to a Y direction and a Z direction. For ease of description, the present description refers to the +Y direction as "upward" and the -Y direction as "downward." This does not limit the orientation of the light-emitting module during use, and the orientation of the light-emitting module may be any chosen orientation.

A light-emitting module 200 illustrated in FIGS. 1A to 1C includes a support base 60, a condensing lens 70, an optical fiber 80, a support member 82 that supports the optical fiber 80, a plurality of slow-axis collimating lenses 92, a plurality of mirror members 94, and a plurality of light-emitting devices 100. Each of the mirror members 94 has a reflective surface 94s.

As illustrated in the FIG. 1B, the support base 60 is disposed on a reference plane Ref parallel to an XZ plane. The reference plane Ref is a reference plane for height in the light-emitting module 200. As illustrated in FIG. 1A, the support base 60 includes a first portion 60-1 that supports the plurality of light-emitting devices 100. The support base 60 further includes a plurality of second portions 60-2 supported by the first portion 60-1. Each of the second portions 60-2 supports the corresponding slow-axis collimating lens 92 and mirror member 94. The support base 60 further includes a third portion 60-3 connected to the first portion 60-1. The third portion 60-3 supports the condensing lens 70 and the optical fiber 80.

The first portion 60-1 includes a plurality of first placement surfaces 60s1 arranged in the X direction. The corresponding second portion 60-2 is disposed on each of the first placement surfaces 60s1. Each of the second portions 60-2 has a second placement surface 60s2. The third portion 60-3 has a third placement surface 60s3.

As illustrated in FIG. 1B, the heights of the plurality of first placement surfaces 60s1 decrease stepwise along the +X direction. The same applies to the heights of the plurality of second placement surfaces 60s2. As illustrated in FIG. 1A, the corresponding light-emitting device 100 is disposed on each of the first placement surfaces 60s1. The corresponding slow-axis collimating lens 92 and mirror member 94 are disposed on each of the second placement surfaces 60s2. When the slow-axis collimating lens 92 and/or the mirror member 94 have a sufficiently large size in the Y direction, the slow-axis collimating lens 92 and/or the mirror member 94 may be disposed on the first placement surface 60s1 without the second portion 60-2. The condensing lens 70 is disposed on the third placement surface 60s3, and the optical fiber 80 is also disposed on the third placement surface 60s3 via the support member 82.

In the example illustrated in FIG. 1B, the height of the third placement surface 60s3 is greater than a minimum height of the plurality of first placement surfaces 60s1 and less than a maximum height thereof. Furthermore, the height of the third placement surface 60s3 is less than a minimum height of the plurality of second placement surfaces 60s2. Depending on the size of the condensing lens 70 in the Y direction, the height of the third placement surface 60s3 may be equal to or less than the minimum height of the plurality of first placement surfaces 60s1. Alternatively, the height of the third placement surface 60s3 may be equal to or greater than the maximum height of the plurality of first placement surfaces 60s1.

In the example illustrated in FIGS. 1A to 1C, the quantity of the light-emitting devices 100 is four, and the quantity of the first placement surfaces 60s1 is four, but the quantity is not limited to these quantities. The quantity of the light-emitting devices 100 may be two, three, or five or more. As the quantity of the light-emitting devices 100 increases, laser beams with a higher output can be obtained. The quantity of the first placement surfaces 60s1 may be two, three, or five or more and may be equal to or greater than the quantity of the light-emitting devices 100.

The support base 60 may be formed of ceramics selected from the group consisting of AlN, SiN, SiC, and alumina, for example. Alternatively, the support base 60 may be formed of at least one metal material selected from the group consisting of Cu, Al, and Ag, for example. The support base 60 may be formed of a metal matrix composite material containing diamond particles dispersed in at least the one metal material selected from the group consisting of Cu, Al, and Ag, for example. The support base 60 may be monolithically formed or may be an assembly of a plurality of parts. The plurality of parts may be formed of the same material as each other or may be formed of different materials from each other. For example, the first portion 60-1, the plurality of second portions 60-2, and the third portion 60-3 may be monolithically formed or may be formed independently of each other. Alternatively, the first portion 60-1 and the third portion 60-3 may be monolithically formed, and the plurality of second portions 60-2 may be formed independently of the first portion 60-1 and the third portion 60-3.

The support base 60 is preferably formed of the metal material selected from the group consisting of Cu, Al, and Ag and is preferably composed of a single member. The metal material is superior to ceramic in terms of heat dissipation and is easy to process due to its softness.

The support base 60 functions as a support base on which the plurality of light-emitting devices 100 are disposed. The support base 60 can also function as a heat sink that transfers heat generated from the plurality of light-emitting devices 100 to the outside, thus reducing an excessive temperature rise of the light-emitting devices 100. In this case, one or a plurality of channels for liquid cooling may be provided inside the support base 60. An example of liquid that can be used for the liquid cooling includes water. A fin structure for air cooling may be provided on the surface of the support base 60. Alternatively, when the support base 60 is disposed on a separately prepared heat sink, the support base 60 can also function as a heat spreader that transfers the heat generated from the plurality of light-emitting devices 100 to the heat sink.

As illustrated in FIGS. 1A and 1C, each of the light-emitting devices 100 emits laser beams L in the +Z direction. As illustrated in FIG. 1A, each of the slow-axis collimating lenses 92 collimates, in the XZ plane, the laser beams emitted from the corresponding light-emitting device 100 and traveling in the +Z direction. As illustrated in FIGS. 1A and 1B, the reflective surface 94s of each of the mirror members 94 reflects the laser beams L that have been emitted from the corresponding light-emitting device 100 and that have been collimated, and changes the traveling direction of the laser beams L to the +X direction toward the condensing lens 70. The laser beams L emitted from each of the light-emitting devices 100 are represented by three thick lines with arrows in the example illustrated in FIG. 1A and are represented by one thick line with an arrow in the examples illustrated in FIGS. 1B and 1C. The reason for the laser beams L being represented by the three thick lines with arrows in the example illustrated in FIG. 1A is to emphasize that the laser beams L have a spread.

The condensing lens 70 includes a fast-axis condensing lens 70a and a slow-axis condensing lens 70b. The fast-axis condensing lens 70a may be a cylindrical lens having a uniform cross-sectional shape in the Z direction, for example, and the slow-axis condensing lens 70b may be a cylindrical lens having a uniform cross-sectional shape in the Y direction, for example. The respective optical axes of the fast-axis condensing lens 70a and the slow-axis condensing lens 70b are parallel to the X direction. The condensing lens 70 may be formed of at least one light-transmissive material selected from the group consisting of glass, silicon, quartz, synthetic quartz, sapphire, transparent ceramics, silicone resin, and plastic.

The fast-axis condensing lens 70a is disposed so that the focal point thereof substantially coincides with a light-incident end 80a of the optical fiber 80. Similarly, the slow-axis condensing lens 70b is disposed so that the focal point thereof substantially coincides with the light-incident end 80a of the optical fiber 80. The focal length of the fast-axis condensing lens 70a is longer than the focal length of the slow-axis condensing lens 70b. As illustrated in FIG. 1B, the fast-axis condensing lens 70a allows the plurality of laser beams L obtained from the laser beams L emitted from the plurality of light-emitting devices 100 to converge on the light-incident end 80a of the optical fiber 80 in the XY plane. As illustrated in FIG. 1A, the slow-axis condensing lens 70b allows the laser beams L having the spread and emitted from the plurality of light-emitting devices 100 to converge on the light-incident end 80a in the XZ plane.

As described above, the laser beams L emitted in the +Z direction from the plurality of light-emitting devices 100 are reflected in the +X direction by the corresponding reflective surface 94s. The plurality of laser beams L obtained in this way can be combined by the condensing lens 70 and allowed to be incident on the optical fiber 80.

As a result, the light-emitting module 200 emits the combined light, in which the plurality of laser beams L are combined, from a light emitting end 80b of the optical fiber 80. Schematically, the output of the combined light is equal to a value obtained by multiplying the output of the laser beams L emitted from the light-emitting devices 100 by the quantity of the light-emitting devices 100. Therefore, if the quantity of the light-emitting devices 100 is increased, the output of the combined light can be increased.

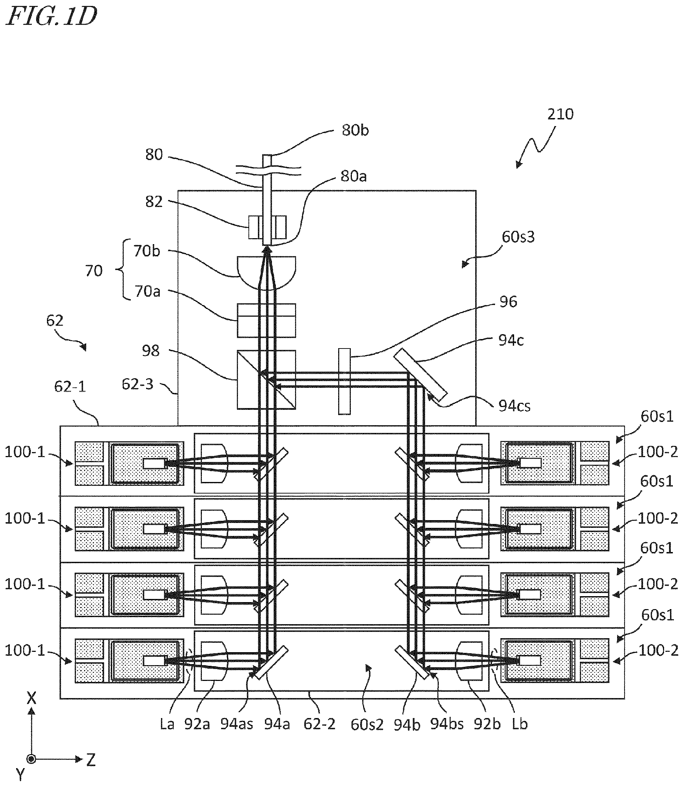

Next, a modified example of the light-emitting module 200 according to an embodiment of the present disclosure will be described with reference to FIG. 1D. FIG. 1D is a top view schematically illustrating a configuration of a modified example of the light-emitting module according to the embodiment of the present disclosure. A light-emitting module 210 illustrated in FIG. 1D differs from the light-emitting module 200 illustrated in FIGS. 1A to 1C in the following three points.

The first point is that the light-emitting module 210 includes a support base 62 instead of the support base 60. The shape of the support base 62 is different from the shape of the support base 60. The second point is that, in addition to a plurality of light-emitting devices 100-1, a plurality of slow-axis collimating lenses 92a, and a plurality of mirror members 94a, the light-emitting module 210 further includes a plurality of light-emitting devices 100-2, a plurality of slow-axis collimating lenses 92b, and a plurality of mirror members 94b. Each of the mirror members 94a has a reflective surface 94as, and each of the mirror members 94b has a reflective surface 94bs. The third point is that the light-emitting module 210 further includes a mirror member 94c, a half-wave plate 96, and a polarizing beam splitter 98. The mirror member 94c includes a reflective surface 94cs.

The support base 62 includes a first portion 62-1 that supports the plurality of light-emitting devices 100-1 and the plurality of light-emitting devices 100-2. The support base 62 further includes a plurality of second portions 62-2 supported by the first portion 62-1. Each of the second portions 62-2 supports the corresponding slow-axis collimating lens 92a, slow-axis collimating lens 92b, mirror member 94a, and mirror member 94b. The support base 62 further includes a third portion 62-3 connected to the first portion 62-1. The third portion 62-3 supports the condensing lens 70, the optical fiber 80, the mirror member 94c, the half-wave plate 96, and the polarizing beam splitter 98.

The first portion 62-1 has the plurality of first placement surfaces 60s1 arranged in the X direction. The corresponding second portion 62-2 is disposed on each of the first placement surfaces 60s1. Each of the second portions 62-2 has the second placement surface 60s2. The third portion 62-3 has the third placement surface 60s3.

The light-emitting device 100-2, the slow-axis collimating lens 92a, and the mirror member 94a have the same structures as the light-emitting device 100, the slow-axis collimating lens 92, and the mirror member 94 illustrated in FIG. 1A, respectively. The same applies to the light-emitting device 100-2, the slow-axis collimating lens 92b, and the mirror member 94b. The light-emitting device 100-1, the slow-axis collimating lens 92a, and the mirror member 94a are arranged in this order along the +Z direction, and the light-emitting device 100-2, the slow-axis collimating lens 92b, and the mirror member 94b are arranged in this order along the -Z direction. The light-emitting device 100-1 and the light-emitting device 100-2 are arranged in an inverted relationship with each other in the Z direction. The same applies to the arrangement of the slow-axis collimating lens 92a and the slow-axis collimating lens 92b, and to the arrangement of the mirror member 94a and the mirror member 94b.

Each of the light-emitting devices 100-1 and each of the light-emitting devices 100-2 are disposed on the corresponding first placement surface 60s1. The light-emitting devices 100-1 emit laser beams La in the +Z direction, and the light-emitting devices 100-2 emit laser beams Lb in the -Z direction. A polarization direction of the laser beams La and Lb is parallel to the X direction. Each of the slow-axis collimating lenses 92a, each of the slow-axis collimating lenses 92b, each of the mirror members 94a, and each of the mirror members 94b are disposed on the corresponding second placement surface 60s2. Each of the slow-axis collimating lenses 92a collimates, in the XZ plane, the laser beams La emitted from the corresponding light-emitting device 100-1 in the +Z direction. Each of the slow-axis collimating lenses 92b collimates, in the XZ plane, the laser beams Lb emitted from the corresponding light-emitting device 100-2 in the -Z direction. The reflective surface 94as of each of the mirror members 94a reflects the collimated laser beams La to change the traveling direction of the laser beams La to the +X direction. The reflective surface 94bs of each of the mirror members 94b reflects the collimated laser beams Lb to change the traveling direction of the laser beams Lb to the +X direction.

The mirror member 94c, the half-wave plate 96, and the polarizing beam splitter 98 are disposed on the third placement surface 60s3. The reflective surface 94cs of the mirror member 94c reflects the laser beams Lb traveling in the +X direction to change the traveling direction of the laser beams Lb to the -Z direction. The half-wave plate 96 changes the polarization direction of the laser beams Lb traveling in the -Z direction from the X direction to the Y direction. The polarizing beam splitter 98 transmits the laser beams La traveling in the +X direction and having the polarization direction in the Z direction and reflects the laser beams Lb traveling in the -Z direction and having the polarization direction in the Y direction. The laser beams La transmitted through the polarizing beam splitter 98 are converged on the light-incident end 80a of the optical fiber 80 by the condensing lens 70. Similarly, the laser beams Lb reflected by the polarizing beam splitter 98 are converged on the light-incident end 80a of the optical fiber 80 by the condensing lens 70.

As a result, the light-emitting module 210 emits the combined light in which the plurality of laser beams La and the plurality of laser beams Lb are combined, from the light emitting end 80b of the optical fiber 80. Compared with the light-emitting module 200 illustrated in FIG. 1A, in the light-emitting module 210 illustrated in FIG. 1D, a total quantity of the light-emitting devices 100-1 and the light-emitting devices 100-2 is twice the quantity of the light-emitting devices 100. Therefore, the output of the combined light can be further increased.

In the light-emitting module 200, when the traveling directions of the plurality of laser beams L are aligned in the +X direction as designed, the plurality of laser beams L can be effectively combined by the condensing lens 70 and can be incident on the optical fiber 80. In the light-emitting module 210, the same applies when the traveling directions of the plurality of laser beams La and the plurality of laser beams Lb are aligned in the +X direction as designed.

In the light-emitting module 200 according to the present embodiment, the corresponding light-emitting device 100 is disposed on each of the plurality of first placement surfaces 60s1 having the mutually different heights, but the light-emitting module 200 is not limited to such a configuration. In addition, the plurality of light-emitting devices 100 may be employed in a more general spatially coupling light-emitting module.

### Light-emitting Device

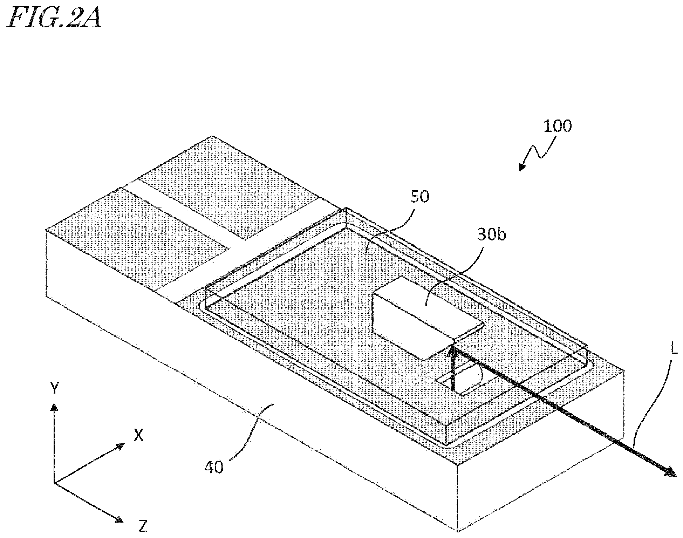

A configuration example of the light-emitting device according to an embodiment of the present disclosure will be described below with reference to FIGS. 2A to 2F. According to the light-emitting device according to the embodiment of the present disclosure, it is possible to reduce the deviation between the traveling direction of the laser beams L and the designed traveling direction. In the present description, when the "traveling direction of the laser beams" or the like is simply denoted as the "traveling direction," the "traveling direction" refers to an actual traveling direction.

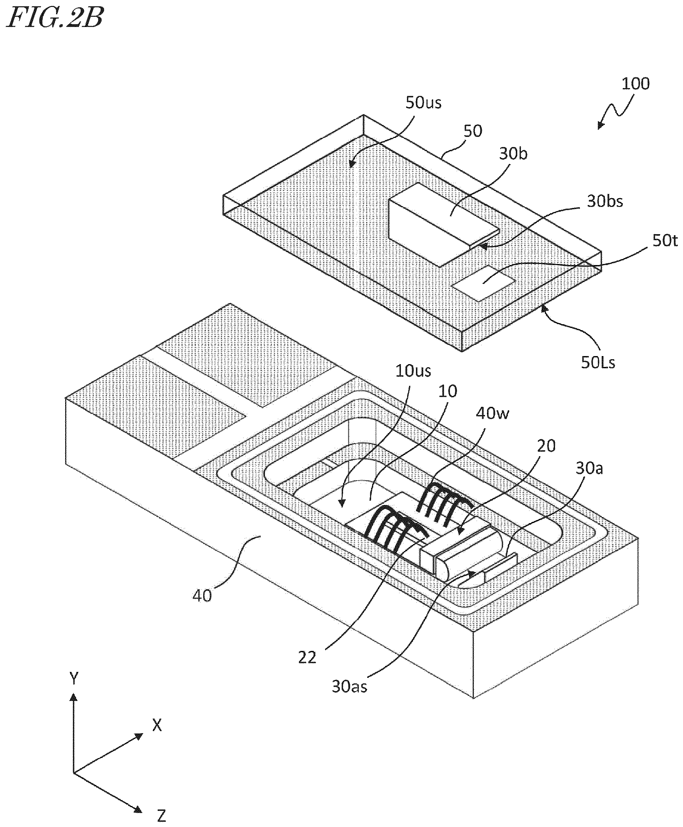

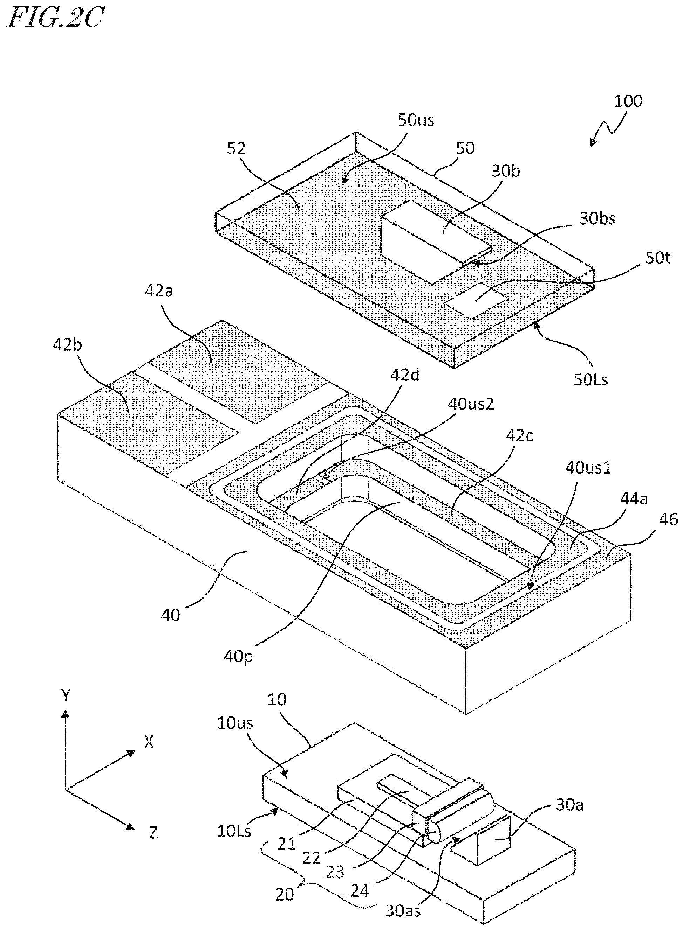

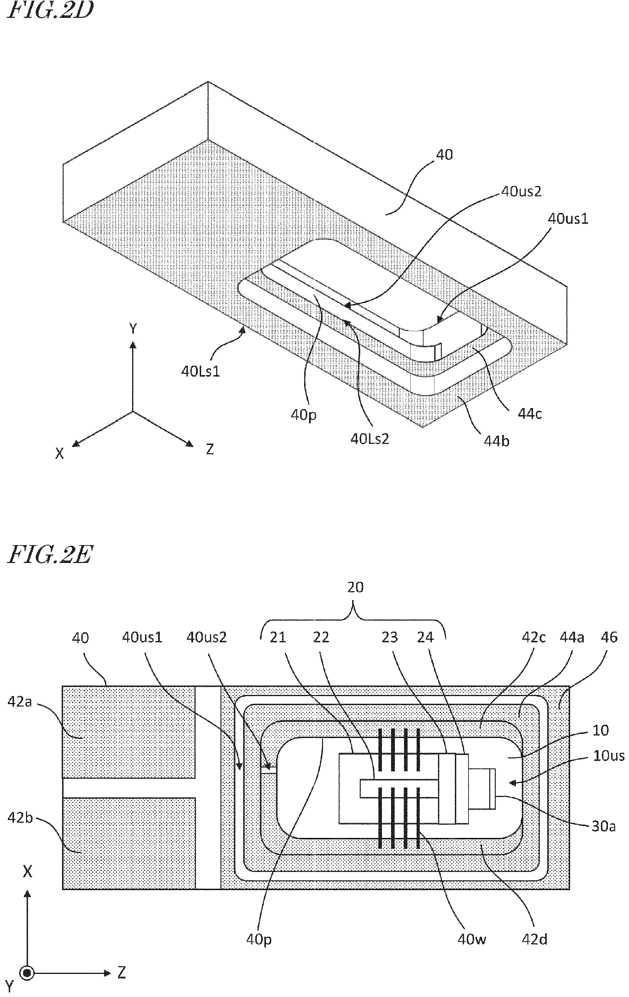

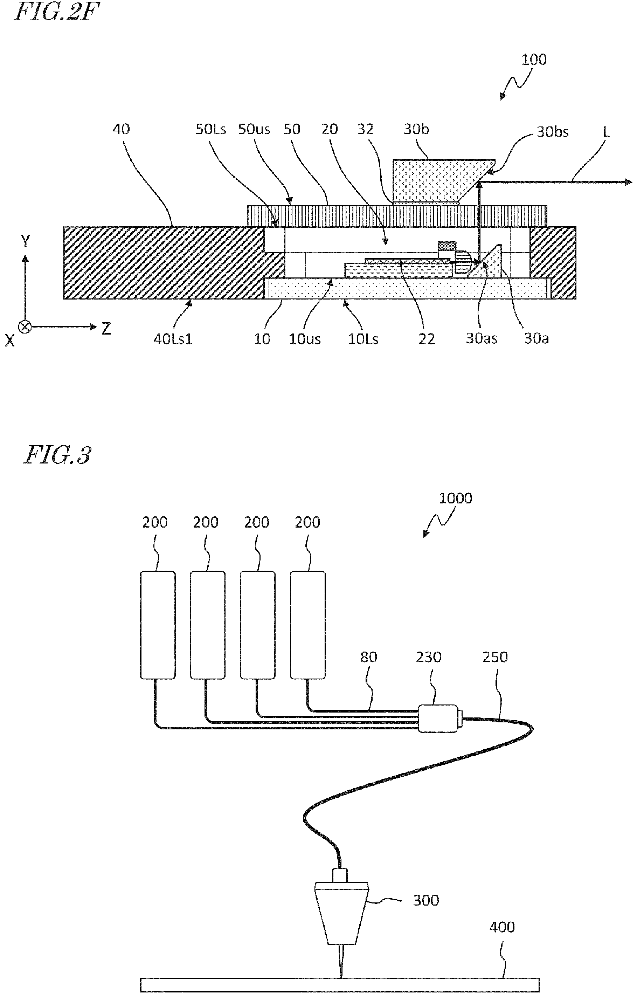

FIG. 2A is a perspective view schematically illustrating the configuration of the light-emitting device according to the exemplary embodiment of the present disclosure. FIG. 2B is an exploded perspective view of the light-emitting device illustrated in FIG. 2A. The light-emitting device 100 illustrated in FIG. 2B includes a substrate 10, a laser light source 20, a first mirror member 30a, a second mirror member 30b, a frame body 40, a plurality of wires 40w, and a cover 50. The substrate 10 has a mounting surface 10us. The first mirror member 30a has a first reflective surface 30as, and the second mirror member 30b has a second reflective surface 30bs. The laser light source 20 is a chip-on-submount semiconductor laser light source including a semiconductor laser element 22. The light-emitting device 100 may further include a protective element, such as a Zener diode, and/or a temperature measuring element for measuring an internal temperature, such as a thermistor. FIG. 2C is another exploded perspective view of the light-emitting device 100 illustrated in FIG. 2A. In FIG. 2C, the plurality of wires 40w illustrated in FIG. 2B is omitted. FIG. 2D is a perspective view of the frame body 40 included in the light-emitting device 100 illustrated in FIG. 2C, as viewed from below. FIG. 2E is a top view of the configuration of the light-emitting device 100 illustrated in FIG. 2A, when the second mirror member 30b and the cover 50 are omitted. FIG. 2F is a cross-sectional view parallel to a YZ plane of the light-emitting device 100 illustrated in FIG. 2A.

As will be described in detail later, in the light-emitting device 100 according to the present embodiment, the laser beams L emitted from the laser light source 20 are reflected by the first reflective surface 30as and the second reflective surface 30bs in this order, as illustrated in FIG. 2F. As a result of such a configuration, regardless of whether or not the traveling direction of the laser beams L emitted from the laser light source 20 deviates from the +Z direction, which is the designed traveling direction, the traveling direction of the laser beams L reflected by the first reflective surface 30as and the second reflective surface 30bs in this order can be directed in the +Z direction. The first reflective surface 30as reflects the laser beams L emitted from the laser light source 20 to change the traveling direction of the laser beams L to a direction away from the mounting surface 10us of the substrate 10. The second reflective surface 30bs reflects the laser beams L reflected by the first reflective surface 30as to further change the traveling direction of the laser beams L to the +Z direction.

The position and orientation of the second mirror member 30b can be adjusted so that the laser beams L reflected by the second reflective surface 30bs travel in the +Z direction. The laser beams L reflected by the second reflective surface 30bs is reflected by the reflective surface 94s as illustrated in FIG. 1A, and therefore the traveling direction of the laser beams L can be changed to the +X direction which is the designed traveling direction. As a result, it is possible to effectively combine the plurality of laser beams L traveling in the +X direction and output the high-power combined light from the light-emitting module 200.

In a configuration in which the traveling direction of the laser beams L incident on the reflective surface 94s is not parallel to the designed +Z direction, the traveling direction of the laser beams L reflected by the reflective surface 94s deviates from the designed +X direction. When such a deviation in the traveling direction occurs in the plurality of laser beams L, even if the deviation is to an extent of a few degrees, for example, there is a possibility that the laser beams L may not be effectively combined and that the output of the combined light may decrease.

In contrast, in the present embodiment, it is possible to reduce the deviation between the traveling direction of the laser beams L, which are reflected by the first reflective surface 30as and the second reflective surface 30bs in this order, and the +Z direction, which is the designed traveling direction. As a result, it is possible to reduce the deviation between the traveling direction of the laser beams L reflected by the reflective surface 94s and the +X direction which is the designed traveling direction. An angle formed between the traveling direction of the laser beams L and the designed traveling direction is preferably equal to or less than 1°, and more preferably equal to or less than 0.1°, for example. In the present description, the angle formed between the two directions has a positive value and does not have a negative value.

In the present embodiment, the designed traveling direction of the laser beams L reflected by the first reflective surface 30as and the second reflective surface 30bs in this order is parallel to the +Z direction, and the designed traveling direction of the laser beams L reflected by the reflective surface 94s is parallel to the +X direction. However, the designed traveling directions are not limited to these directions.

In the present description, the direction in which the plurality of first placement surfaces 60s1 are arranged is referred to as a "first direction," and the traveling direction of the laser beams L reflected by the first reflective surface 30as and the second reflective surface 30bs in this order is referred to as a "second direction." The reference plane Ref is parallel to the first direction. In the present embodiment, the first direction is the +X direction, and the second direction is the +Z direction, but the directions are not limited to these examples. The second direction does not need to be orthogonal to the first direction as long as it intersects the first direction.

The light-emitting device 100 may be used for other applications instead of being used for the light-emitting module 200 illustrated in FIGS. 1A and 1B.

Each of components of the light-emitting device 100 will be described below.

### Substrate 10

As illustrated in FIG. 2C, the substrate 10 has the mounting surface 10us and a lower surface 10Ls. The normal direction of the mounting surface 10us is the +Y direction. In the present description, the normal direction of a surface means a direction perpendicular to the surface and separating from an object having the surface. In the example illustrated in FIG. 2C, the substrate 10 has a rectangular flat plate shape, but is not limited to this shape. The substrate 10 may have a polygonal, a circular, or an elliptical flat plate shape, for example. The lower surface 10Ls of the substrate 10 is bonded to the first placement surface 60s1 of the support base 60 via an inorganic bonding member, such as a solder material, for example.

The substrate 10 may be formed of a material having a thermal conductivity in a range from 10 W/m · K to 2000 W/m · K, for example. Due to the substrate 10 having such a high thermal conductivity, heat generated from the laser light source 20 during driving can be effectively transferred to the support base 60 illustrated in FIGS. 1A to 1C, via the substrate 10. The substrate 10 may be formed of the same material as the support base 60, for example. The size of the substrate 10 in the X direction may be in a range from 1000 µm to 10000 µm, for example, the size in the Y direction may be in a range from 100 µm to 5000 µm, for example, and the size in the Z direction may be in a range from 1000 µm to 20000 µm, for example.

### Laser Light Source 20

As illustrated in FIG. 2C, the laser light source 20 is supported by the mounting surface 10us of the substrate 10. The laser light source 20 includes a submount 21, the end-face emission type semiconductor laser element 22 supported by the submount 21, a lens support member 23, and a fast-axis collimating lens 24. The semiconductor laser element 22 is supported by the mounting surface 10us of the substrate 10 via the submount 21. The semiconductor laser element 22 is disposed so as to emit the laser beams L toward the first reflective surface 30as. The lens support member 23 has a shape straddling the semiconductor laser element 22. The fast-axis collimating lens 24 is supported by an end surface of the lens support member 23. The components of the laser light source 20 may be treated as components of the light-emitting device 100.

The semiconductor laser element 22 emits the laser beams L from a rectangular end surface thereof. When the end surface extends in the X direction and is a plane parallel to the XY plane, the laser beams L emitted from the semiconductor laser element 22 in the +Z direction spread relatively quickly in the YZ plane and spread relatively slowly in the XZ plane. The fast axis direction of the laser beams L is parallel to the Y direction, and the slow axis direction is parallel to the X direction.

The laser light source 20 emits the laser beams that have been emitted from the semiconductor laser element 22 and passed through the fast-axis collimating lens 24. The laser beams L emitted from the laser light source 20 are collimated in the YZ plane, but are not collimated in the XZ plane. In the present description, "collimating" refers to not only making the laser beams L parallel light but also reducing the spread angle of the laser beams L. A specific configuration of the laser light source 20 will be described later.

As illustrated in FIG. 2F, the semiconductor laser element 22 included in the laser light source 20 is sealed by the substrate 10, the frame body 40, and the cover 50. This seal is preferably a hermetic seal. The effect of the hermetic seal increases the shorter the wavelength of the laser beams emitted from the semiconductor laser element 22. This is because, in a configuration in which the emission surface of the semiconductor laser element 22 is not hermetically sealed and is in contact with the outside air, the shorter the wavelength of the laser beams is, the higher the possibility that degradation of the emission surface will progress due to dust collecting during operation.

Instead of the end-face emission type semiconductor laser element 22, a surface light emitting type semiconductor laser element, such as a vertical-cavity surface-emitting laser (VCSEL) element, may also be used. The surface light emitting type semiconductor laser element is disposed such that the laser beams emitted from the semiconductor laser element travel in the +Z direction.

### First Mirror Member 30a and Second Mirror Member 30b

As illustrated in FIG. 2C, the first mirror member 30a is supported by the mounting surface 10us of the substrate 10. The first mirror member 30a has a uniform cross-sectional shape in the X direction. The cross-sectional shape is substantially triangular. The first mirror member 30a has a lower surface, a back surface, and an inclined surface connecting the lower surface and the back surface. The lower surface is parallel to the XZ plane and the back surface is parallel to the XY plane. The normal direction of the inclined surface is a direction that is parallel to the YZ plane, forms an acute angle with the +Y direction, and forms an acute angle with the -Z direction. An angle formed between the lower surface and the inclined surface of the first mirror member 30a is 45°, but is not limited to this angle, and may be in a range from 30° to 60°, for example.

The first mirror member 30a has the first reflective surface 30as on its inclined surface. The first reflective surface 30as is inclined with respect to the mounting surface 10us of the substrate 10 and faces obliquely upward. In the present description, "obliquely upward" means a direction forming an angle in a range from 30° to 60° with the +Y direction. The normal direction of the first reflective surface 30as may or does not need to be parallel to the YZ plane as long as the first reflective surface 30as can receive the laser beams L emitted from the laser light source 20 and the normal direction of the first reflective surface 30as forms the angle in the range from 30° to 60° with the +Y direction.

As illustrated FIG. 2F, the first reflective surface 30as reflects the laser beams L emitted from the laser light source 20 to change the traveling direction of the laser beams L to the direction away from the mounting surface 10us of the substrate 10. An angle formed between the direction in which the laser beams L travel away from the mounting surface 10us of the substrate 10 and the normal direction of the mounting surface 10us may be in a range from 0° to 5°, for example. Because this angle has a tolerance of 5°, it is not necessary to adjust the position and orientation of the first mirror member 30a with as much precision as the position and orientation of the second mirror member 30b.

As illustrated in FIG. 2C, the second mirror member 30b is supported by an upper surface 50us of the cover 50. The second mirror member 30b has a uniform cross-sectional shape in the X direction. The cross-sectional shape is substantially trapezoidal. The second mirror member 30b has an upper surface, a lower surface, and an inclined surface connecting the upper surface and the lower surface. Each of the upper surface and the lower surface is parallel to the XZ plane. The size of the lower surface in the X direction is equal to the size of the upper surface in the X direction. On the other hand, the size of the lower surface in the Z direction is smaller than the size of the upper surface in the Z direction. The normal direction of the inclined surface is a direction that is parallel to the YZ plane, forms an acute angle with the -Y direction, and forms an acute angle with the +Z direction. An angle formed between the upper surface and the inclined surface of the second mirror member 30b is 45°, but is not limited to this angle, and may be in a range from 30° to 60°, for example. The angle formed between the upper surface and the inclined surface of the second mirror member 30b may be equal to or different from the angle formed between the lower surface and the inclined surface of the first mirror member 30a.

The second mirror member 30b has the second reflective surface 30bs on its inclined surface. At least a portion of the second reflective surface 30bs is positioned above at least a portion of the first reflective surface 30as. As illustrated in FIG. 2F, the second reflective surface 30bs reflects the laser beams L reflected by the first reflective surface 30as to change the traveling direction of the laser beams L to the +Z direction.

A resin layer 32 is provided between the lower surface of the second mirror member 30b and the upper surface 50us of the cover 50, as illustrated in FIG. 2F. With the lower surface of the second mirror member 30b in contact with the upper surface 50us of the cover 50 via the uncured resin, the resin is cured to form the resin layer 32. The resin may be, for example, a thermosetting resin that is cured by heating, or a photocurable resin that is cured by irradiation with ultraviolet rays or visible light. Before the resin is cured, the following active alignment is performed. That is, the position and the orientation of the second mirror member 30bs are appropriately adjusted so that the second reflective surface 30b changes the traveling direction of the laser beams L to the +Z direction with the laser light source 20 emitting the laser beams L. Such an adjustment may be performed while holding the second mirror member 30b using a holding device, after the light-emitting device 100 is disposed on the first placement surface 60s1 of the support base 60 illustrated in FIGS. 1A to 1C.

The traveling direction of the laser beams L can be adjusted by rotating the second mirror member 30b about the X-axis or the Y-axis as a rotation axis, to change the orientation thereof. Rotating the second mirror member 30b about the X-axis as the rotation axis can change the traveling direction of the laser beams L up and down. Rotating the second mirror member 30b about the Y-axis as the rotation axis can change the traveling direction of the laser beams L right and left, with the traveling direction of the laser beam L being the front direction.

Furthermore, a height of an optical axis of the laser beams L can be adjusted by changing the position of the second mirror member 30b in the Z direction. The height of the optical axis of the laser beams L can be reduced by shifting the second mirror member 30b along the +Z direction, and the height of the optical axis of the laser beams L can be increased by shifting the second mirror member 30b along the -Z direction. In the present description, the "optical axis of the laser beams" means an axis passing through the center of a far field pattern of the laser beams. The laser beams traveling along the optical axis exhibit a peak intensity in a light intensity distribution of the far field pattern.

Here, in contrast to the present embodiment, a configuration in which the second mirror member 30b is fixed to the upper surface 50us of the cover 50 without adjusting the position and orientation thereof will be described as an example. Even with such a configuration, by disposing a wedge between the second mirror member 30b and the slow-axis collimating lens 92 in the light-emitting module 200 illustrated in FIGS. 1A to 1C, the traveling direction of the laser beams L reflected by the second reflective surface 30bs can be directed to the +Z direction. The wedge has a light incident surface and a light reflective surface positioned on sides opposite to each other. The normal direction of the light incident surface is parallel to the -Z direction. The normal direction of a light-emitting surface is parallel to the YZ plane, forms an acute angle with the +Y direction or the -Y direction, and forms an acute angle with the +Z direction. Due to the light incident surface and the refraction at the light incident surface which are not parallel to each other, the wedge can change the traveling direction of the laser beams L transmitted through the wedge. However, when using the wedge, to direct the traveling direction of the laser beams L to the +Z direction, it is necessary to prepare a plurality of the wedges for which the normal directions of the light-emitting surfaces are mutually different to select the wedge having the appropriate normal direction of the light-emitting surface from among the plurality of wedges.

In contrast, in the present embodiment, disposing the second mirror member 30b in an appropriate position and orientation allows the traveling direction of the laser beams L reflected by the second reflective surface 30bs to be directed to the +Z direction, regardless of whether the traveling direction of the laser beams L emitted from the laser light source 20 is deviated from the +Z direction. In the present embodiment, it is not necessary to prepare a plurality of the second mirror members 30b having mutually different angles formed between the upper surface and the inclined surface to select the second mirror member 30b having the appropriate angle from among the plurality of second mirror members 30b.

The mirror members 30a and 30b illustrated in FIGS. 2B and 2C, the mirror member 94 illustrated in FIGS. 1A to 1C, and the mirror members 94a to 94c illustrated in FIG. 1D may, for example, include a base having an inclined surface and a reflective surface as an individual member formed on the inclined surface. The base may be formed of at least one material selected from the group consisting of glass, quartz, synthetic quartz, sapphire, ceramics, plastic, silicon, metal, silicone resin, and a dielectric material, for example. The reflective surface may be formed from a reflective material, such as a dielectric multilayer film and a metal material, for example. This reflective surface corresponds to the first reflective surface 30as and the second reflective surface 30bs illustrated in FIG. 2B, to the reflective surface 94s illustrated in FIG. 1A, and to the reflective surfaces 94as to 94cs illustrated in FIG. 1D.

Alternatively, the first mirror member 30a, the second mirror member 30b, the mirror member 94, and the mirror members 94a to 94c may include a base having an inclined surface, for example, and the base may be formed of the above-described reflective material. In this case, the inclined surface of the base corresponds to the first reflective surface 30as, to the second reflective surface 30bs, to the reflective surface 94s, and to the reflective surfaces 94as to 94cs.

### Frame Body 40

The frame body 40 is positioned around the mounting surface 10us of the substrate 10, as illustrated in FIG. 2B, and supports the cover 50 as illustrated in FIG. 2A. As illustrated in FIG. 2B, the frame body 40 surrounds the laser light source 20 and the first mirror member 30a when seen along the +Y direction, that is, in a top view. As illustrated in FIG. 2C, the frame body 40 includes a protruding portion 40p protruding inward from the inner surface. In the example illustrated in FIG. 2E, the protruding portion 40p protrudes toward both lateral surfaces and the back surface of the submount 21. The protruding portion 40p may further protrude toward the front surface of the submount 21. Further, the protruding portion 40p may protrude only to both the lateral surfaces. The front surface of the submount 21 is positioned on the same side as the emission surface of the semiconductor laser element 22, and the back surface of the submount 21 is positioned on the side opposite to the emission surface of the semiconductor laser element 22. Both the lateral surfaces of the submount 21 connect the front surface and the back surface of the sub-mount 21.

As illustrated in FIG. 2C, the frame body 40 has a first upper surface 40us1 and a second upper surface 40us2. The second upper surface 40us2 is an upper surface of the protruding portion 40p, is positioned lower than the first upper surface 40us1, and is surrounded by the first upper surface 40us1 in a top view. As illustrated in FIG. 2E, the second upper surface 40us2 has a substantial U-shape.

The first upper surface 40us1 includes a first bonding region 44a and an outer region 46 surrounding the first bonding region 44a. Each of the first bonding region 44a and the outer region 46 has a substantially rectangular annular shape. The first bonding region 44a improves a bonding strength when the cover 50 and the frame body 40 are bonded to each other via an inorganic bonding member, such as a solder material. The outer region 46 suppresses the inorganic bonding member that bonds the cover 50 from flowing out beyond the outer region 46. As illustrated in FIG. 2E, the first bonding region 44a and the outer region 46 surround the laser light source 20 and the first mirror member 30a in a top view. A first conductive region 42a and a second conductive region 42b, which are electrically insulated from each other, are further provided on the first upper surface 40us1, at a position extended in the -Z direction from the first bonding region 44a and the outer region 46.

A third conductive region 42c and a fourth conductive region 42d, which are electrically insulated from each other, are provided on the second upper surface 40us2. The third conductive region 42c is electrically connected to the first conductive region 42a via internal wiring, and the fourth conductive region 42d is electrically connected to the second conductive region 42b via internal wiring. As illustrated in FIG. 2E, in a top view, the laser light source 20 and the first mirror member 30a are positioned between a portion of the third conductive region 42c extending in the Z direction and a portion of the fourth conductive region 42d extending in the Z direction. The third conductive region 42c is electrically connected to the semiconductor laser element 22 via the upper surface of the submount 21 and one or more the wires 40w illustrated in FIG. 2B. The fourth conductive region 42d is electrically connected to the semiconductor laser element 22 via the remaining wires 40w illustrated in FIG. 2B. Therefore, by applying a voltage between the first conductive region 42a and the second conductive region 42b, power can be supplied to the laser light source 20.

As illustrated in FIG. 2D, the frame body 40 further includes a first lower surface 40Ls1 and a second lower surface 40Ls2. The second lower surface 40Ls2 partially has the lower surface of the protruding portion 40p, is positioned higher than the first lower surface 40Ls1, and is surrounded by the first lower surface 40Ls1 when seen along the -Y direction, that is, in a bottom view. The second lower surface 40Ls2 has a substantially rectangular annular shape. A part or all of the substrate 10 illustrated in FIG. 2C is accommodated in a space surrounded by a step between the first lower surface 40Ls1 and the second lower surface 40Ls2. When viewed through the frame body 40, the outer periphery of the second lower surface 40Ls2 surrounds the outer periphery of the mounting surface 10us of the substrate 10 in a top view, and the inner periphery of the second lower surface 40Ls2 is surrounded by the outer periphery of the mounting surface 10us of the substrate 10 in a top view.

A second bonding region 44b is provided over the entire first lower surface 40Ls1. The second bonding region 44b improves a bonding strength when the support base 60 and the frame body 40 illustrated in FIGS. 1A to 1C are bonded to each other via an inorganic bonding member, such as a solder material. A third bonding region 44c is provided over the entire second lower surface 40Ls2. The third bonding region 44c is bonded to a peripheral edge region of the mounting surface 10us of the substrate 10 via an inorganic bonding member, such as a brazing material. The third bonding region 44c improves a bonding strength when the substrate 10 and the frame body 40 are bonded via the inorganic bonding member. The melting point of the brazing material is higher than the melting point of the solder material. Therefore, when the brazing material is heated to bond the substrate 10 and the frame body 40, and subsequently the solder material is heated to bond the substrate 10 and the laser light source 20, it is possible to reduce the possibility that the bonding of the substrate 10 and the frame body 40 may come off as a result of the heat applied to the solder material.

In the example illustrated in FIG. 2D, the second bonding region 44b is provided over the entire first lower surface 40Ls1, but the second bonding region 44b may be provided on a part of the first lower surface 40Ls1. Similarly, in the example illustrated in FIG. 2D, the third bonding region 44c is provided over the entire second lower surface 40Ls2, but the third bonding region 44c may be provided on a part of the second lower surface 40Ls2. Alternatively, the second bonding region 44b does not need to be provided on the first lower surface 40Ls1, and the third bonding region 44c does not need to be provided on the second lower surface 40Ls2. When the second bonding region 44b is not provided on the first lower surface 40Ls1, the substrate 10 and the support base 60 are bonded only at the lower surface 10Ls of the substrate 10, without bonding the frame body 40 and the support base 60.

In the example illustrated in FIG. 2F, the first lower surface 40Ls1 of the frame body 40 is positioned on the same plane as the lower surface 10Ls of the substrate 10. The first lower surface 40Ls1 of the frame body 40 may be positioned higher than the lower surface 10Ls of the substrate 10. Alternatively, the first lower surface 40Ls1 of the frame body 40 may be positioned lower than the lower surface 10Ls of the substrate 10, if the first lower surface 40Ls1 does not cause obstruction when bonding the substrate 10 and the support base 60 via the inorganic bonding member.

Similar to the support base 60 illustrated in FIGS. 1A and 1B, the frame body 40 may be formed of the above-described ceramics, for example. The size of the frame body 40 in the X direction may be in a range from 3 mm to 15 mm, for example, the maximum size thereof in the Y direction may be in a range from 1 mm to 5 mm, for example, and the size thereof in the Z direction may be in a range from 3 mm to 30 mm, for example.

The conductive regions 42a to 42d, the bonding regions 44a to 44c, and the outer region 46 may be formed of at least one metal material selected from the group consisting of Ag, Cu, W, Au, Ni, Pt, and Pd, for example. The conductive regions 42a to 42d, the bonding region 44a, and the outer region 46 can be formed, for example, by providing a metal film over the entire upper surfaces 40us1 and 40us2 and patterning the metal film by etching.

### Cover 50

As illustrated in FIG. 2B, the cover 50 has an upper surface 50us and a lower surface 50Ls. The lower surface 50Ls of the cover 50 faces the mounting surface 10us of the substrate 10, and the upper surface 50us of the cover 50 is positioned on the side opposite to the lower surface 50Ls of the cover 50. In the present description, the lower surface 50Ls of the cover 50 is also referred to as a "facing surface." The cover 50 is positioned above the semiconductor laser element 22 and the first mirror member 30a. The cover 50 transmits the laser beams L reflected by the first reflective surface 30as.

The cover 50 includes a light-shielding film 52 on a portion of the lower surface 50Ls where is positioned at least around a light-transmitting region 50t through which the laser beams L are transmitted. In the example illustrated in FIG. 2C, the light-transmitting region 50t has a rectangular shape, but the shape is not limited to this shape. The shape of the light-transmitting region 50t may be, for example, a circular shape or an elliptical shape.

Alternatively, the cover 50 may include the light-shielding film 52 on a portion of the lower surface 50Ls where is positioned at least a portion around the light-transmitting region 50t. For example, when a part of an end of the light-transmitting region 50t coincides with a part of an end of the lower surface 50Ls, the light-shielding film 52 may be provided on at least a part of a region described below on the lower surface 50Ls. This region is a region of the lower surface 50Ls where is adjacent to the remaining part other than the above-described part of the end of the light-transmitting region 50t.

The light-shielding film 52 reduces the possibility of stray light other than the laser beams L generated inside the light-emitting device 100 leaking to the outside of the light-emitting device 100. The light-shielding film 52 further reduces the possibility of ultraviolet rays or visible light reaching the laser light source 20 when the resin layer 32 illustrated in FIG. 2F is formed by the irradiation of the ultraviolet rays or visible light. The light-shielding film 52 further reduces the possibility that return light of the laser beams L emitted to the outside of the light-emitting device 100 may reach the laser light source 20. If irradiation by the ultraviolet rays, the visible light, or the return light can be reduced, the laser light source 20 is less likely to be damaged.

In the example illustrated in FIG. 2C, the light-shielding film 52 is provided over the entire region other than the light-transmitting region 50t on the lower surface 50Ls. The light-shielding film 52 provided in such a manner further reduces the possibility of the stray light leaking to the outside of the light-emitting device 100 and the possibility of the above-described ultraviolet rays, visible light, or return light reaching the laser light source 20.

The laser beams L are transmitted not only through the light-transmitting region 50t but also through a part of the cover 50 that overlaps the light-transmitting region 50t in a top view. The part of the cover 50 that transmits the laser beams L may have a transmittance of the laser beams L equal to or greater than 60%, for example, and preferably has a transmittance of the laser beams L equal to or greater than 80%. The remaining part of the cover 50 may or does not need to have such light-transmissive properties.

Similar to the condensing lens 70 illustrated in FIGS. 1A and 1B, the cover 50 may be formed of the above-described light-transmissive material, for example. The size of the cover 50 in the X direction may be in a range from 3 mm to 15 mm, for example, the size thereof in the Y direction may be in a range from 0.1 mm to 1.5 mm, for example, and the size thereof in the Z direction may be in a range from 1 mm to 20 mm, for example.

Similar to the conductive regions 42a to 42d, the bonding regions 44a to 44c, and the outer region 46, the light-shielding film 52 may be formed of the above-described metal material, for example. Similar to the conductive regions 42a to 42d, the bonding region 44a, and the outer region 46, the light-shielding film 52 may be formed, for example, by providing a metal film over the entire lower surface 50Ls of the cover 50 and patterning the metal film by etching.

The peripheral region of the light-shielding film 52 is bonded to the first bonding region 44a provided on the first upper surface 40us1 of the frame body 40, via an inorganic bonding member such as a solder material. When the light-shielding film 52 is formed of the above-described metal material, the light-shielding film 52 improves the bonding strength when the cover 50 and the frame body 40 are bonded to each other via the inorganic bonding member.

In the example illustrated in FIGS. 2A to 2C, the cover 50 has a flat plate shape, but is not limited to this shape. In a configuration in which the substrate 10 has a flat plate shape without the frame body 40 provided, the cover 50 may have a box shape with an open lower portion instead of the flat plate shape. The cover 50 having such a shape is supported by the mounting surface 10us of the substrate 10 and accommodates the laser light source 20 and the first mirror member 30a. Further, a configuration may be adopted in which the cover 50 having the box shape with the open lower portion is bonded to the frame body 40, and the laser light source 20 and the first mirror member 30a may be surrounded by the cover 50 and the frame body 40.

As described above, the present embodiment provides the light-emitting device 100 that can reduce the deviation between the traveling direction of the laser beams L and the designed traveling direction. By employing such a light-emitting device 100 in the light-emitting module 200 illustrated in FIGS. 1A to 1C, the plurality of laser beams L obtained from the laser beams L emitted from the plurality of light-emitting devices 100 can be effectively combined and allowed to be incident on the optical fiber 80.

The light-emitting device 100 may be manufactured in the following manner. In an initial step, the substrate 10, the laser light source 20, the first mirror member 30a, the second mirror member 30b, the frame body 40, the plurality of wires 40w, and the cover 50 are prepared. In a subsequent step, the frame body 40 is bonded to the substrate 10. In a subsequent step, the laser light source 20 and the first mirror member 30a are provided on the mounting surface 10us of the substrate 10. In a subsequent step, the plurality of wires 40w for supplying the power to the laser light source 20 is provided. In a subsequent step, the cover 50 is bonded to the frame body 40. In a subsequent step, active alignment is performed with the lower surface of the second mirror member 30b in contact with the upper surface 50us of the cover 50 via the uncured resin. In a subsequent step, the resin is cured and the resin layer 32 is formed between the second mirror member 30b and the cover 50.

### DDL Device

Next, with reference to FIG. 3, a configuration example of a DDL device according to an embodiment of the present disclosure will be described. FIG. 3 is a top view schematically illustrating the configuration of the DDL device according to the exemplary embodiment of the present disclosure. A DDL device 1000 illustrated in FIG. 3 includes a plurality of the light-emitting modules 200 according to the present embodiment, a processing head 300, and an optical transmission fiber 250 connecting the light-emitting modules 200 to the processing head 300. In the example illustrated in FIG. 3, the quantity of the light-emitting modules 200 is four, but the configuration is not limited to this quantity. The quantity of the light-emitting modules 200 may be one or may be two, three, or five or more.

The quantity of the light-emitting devices 100 included in each of the light-emitting modules 200 is determined according to the required light output or irradiance. The wavelengths of the laser beams emitted from the light-emitting device 100 may also be selected in accordance with the material to be processed. In processing, for example, a metal such as copper, brass, or aluminum, the semiconductor laser element having a center wavelength in a range from 350 nm to 550 nm may be favorably employed. The wavelengths of the laser beams emitted from each of the light-emitting devices 100 do not need to be the same, and laser beams having different center wavelengths may be superimposed. The effects according to the present invention can also be obtained in using laser beams having a center wavelength outside the range from 350 nm to 550 nm.

In the example illustrated in FIG. 3, the optical fiber 80 extends from each of the plurality of light-emitting modules 200. The plurality of optical fibers 80 thus obtained is connected to the optical transmission fiber 250 by an optical multiplexer 230. The optical multiplexer 230 may be, for example, a tapered fiber bundle (TFB). The processing head 300 converges and irradiates the laser beams emitted from the light emission end of the optical fibers 80 onto an object 400. When the one DDL device 1000 includes M of the light-emitting modules 200 and each of the light-emitting modules 200 includes N of the light-emitting devices 100, if the light output of the one light-emitting device 100 is P watts, a laser beam having a maximum light output of P × N × M watts can be focused on the target 400. Here, N is an integer of 2 or more, and M is a positive integer. For example, if P is 20 watts, N is 22, and M is 12, a light output in excess of 5 kilowatts can be achieved.

### Configuration of Laser Light Source 20

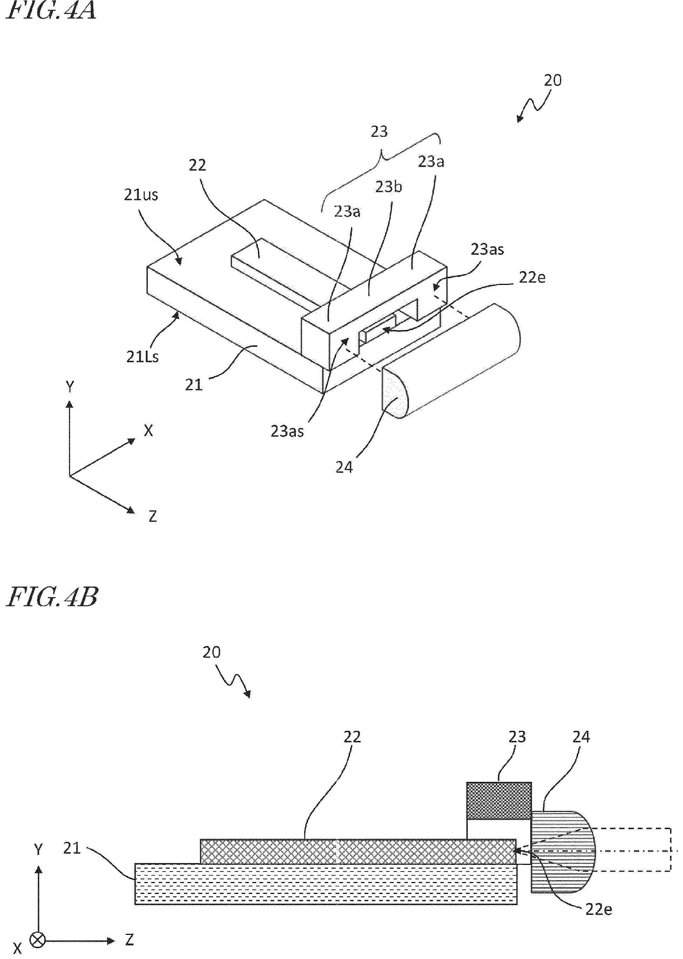

Next, a configuration example of the laser light source 20 illustrated in FIG. 2C will be described with reference to FIGS. 4A and 4B. FIG. 4A is an exploded perspective view of the laser light source 20. 4B is a cross-sectional view of the laser light source 20 parallel to the YZ plane. Each of the components of the laser light source 20 will be described below.

As illustrated in FIG. 4A, the submount 21 has an upper surface 21us and a lower surface 21Ls that are parallel to the XZ plane. A metal film is provided on each of the upper surface 21us and the lower surface 21Ls. The metal film provided on the upper surface 21us improves the bonding strength when the semiconductor laser element 22 and the lens support member 23 are bonded to the submount 21 by an inorganic bonding member. The metal film provided on the upper surface 21us may be further used to supply electric power to the semiconductor laser element 22. The metal film provided on the lower surface 21Ls improves the bonding strength when the substrate 10 and the laser light source 20 illustrated in FIG. 2C are bonded to each other via the inorganic bonding member. The metal films provided on each of the upper surface 21us and the lower surface 21Ls also serve to transfer heat generated by the semiconductor laser element 22 during driving to the substrate 10, via the submount 21. Similar to the support base 60 illustrated in FIGS. 1A and 1B, the submount 21 can be formed of the above-described ceramics, metal material, or metal-matrix composite material, for example.

As illustrated in FIG. 4A, the semiconductor laser element 22 is supported by the upper surface 21us of the submount 21. The semiconductor laser element 22 has an emission surface 22e on one of two end surfaces intersecting the Z direction, and emits the laser beams from the emission surface 22e in the +Z direction. The laser beam spreads at different speed in the YZ plane and the XZ plane as it travels in the +Z direction. The laser beam spreads relatively fast in the YZ plane and spread relatively slowly in the XZ plane. When the laser beam is not collimated, in the far field, the spot of the laser beam has an elliptical shape in which the Y direction is the long axis and the X direction is the short axis in the XY plane.

The semiconductor laser element 22 can emit violet, blue, green, or red laser light in the visible region, or infrared or ultraviolet laser light in the invisible region. The light emission peak wavelength of the violet light is preferably in a range from 400 nm to 420 nm, and more preferably in a range from 400 nm to 415 nm. The light emission peak wavelength of the blue light is preferably in a range from 420 nm to 495 nm, and more preferably in a range from 440 nm to 475 nm. The light emission peak wavelength of the green light is preferably in a range from 495 nm to 570 nm, and more preferably in a range from 510 nm to 550 nm. The light emission peak wavelength of the red light is preferably in a range from 605 nm to 750 nm, and more preferably in a range from 610 nm to 700 nm.

Examples of the semiconductor laser element 22 that emits the violet light, blue light, and the green light include a laser diode including a nitride semiconductor material. For example, GaN, InGaN, and AlGaN can be used as the nitride semiconductor material. Examples of the semiconductor laser element 22 that emits the red light include a laser diode including an InAlGaP-based, a GaInP-based, a GaAs-based, and a AlGaAs-based semiconductor material.

As illustrated in FIG. 4A, the lens support member 23 is supported by the upper surface 21us of the submount 21. The lens support member 23 includes two columnar portions 23a and a link portion 23b that is positioned between the two columnar portions 23a and links the two columnar portions 23b. The two columnar portions 23a are positioned on both sides of the semiconductor laser element 22, and the link portion 23b is positioned above the emission surface 22e side of the semiconductor laser element 22. The lens support member 23 supports the fast-axis collimating lens 24 using end surfaces 23as of the two columnar portions 23a. The lens support member 23 is positioned straddling the semiconductor laser element 22 and does not obstruct the laser beams emitted from the semiconductor laser element 22 from being incident on the fast-axis collimating lens 24.

Similar to the support base 60 illustrated in FIGS. 1A and 1B, the lens support member 23 may be formed of the above-described ceramics, for example. Similar to the condensing lens 70 illustrated in FIGS. 1A and 1B, the lens support member 23 may be formed of the above-described light-transmissive material, for example. The lens support member 23 may be formed of at least one alloy selected from the group consisting of Kovar and CuW, for example. The lens support member 23 may be formed of Si, for example.

As illustrated in FIG. 4A, the fast-axis collimating lens 24 may be, for example, a cylindrical lens having a uniform cross-sectional shape in the X direction. The fast-axis collimating lens 24 has a flat surface on a light incident side and a convex curved surface on a light emitting side. The convex curved surface has a curvature in the YZ plane. The focal point of the fast-axis collimating lens 24 substantially coincides with a center of a light emission point of the emission surface 22e of the semiconductor laser element 22. As illustrated in FIG. 4B, the fast-axis collimating lens 24 collimates the laser beams emitted in the +Z direction from the emission surface 22e of the semiconductor laser element 22, in the YZ plane. A region surrounded by a broken line illustrated in FIG. 4B represents a region in which the intensity of the laser beams is 1/e² times or more of the peak intensity. where "e" is the base of a natural logarithm. Similar to the condensing lens 70 illustrated in FIG. 1A and FIG. 1B, the fast-axis collimating lens 24 may be formed of the above-described light-transmissive material, for example.

As illustrated in FIG. 2F, the fast-axis collimating lens 24 is positioned between the mounting surface 10us of the substrate 10 and the lower surface 50Ls of the cover 50, and is positioned on the optical path of the laser beams L. Because the fast-axis collimating lens 24 is disposed inside the sealed space formed by the substrate 10, the frame body 40, and the cover 50, the laser beams L can be collimated before the laser beams L spread significantly. Therefore, the size of the fast-axis collimating lens 24 can be reduced.

Instead of the fast-axis collimating lens 24, a collimating lens may be used that collimates the laser beams L emitted from the semiconductor laser element 22 not only in the YZ plane but also in the XZ plane. In this case, it is not necessary to provide the slow-axis collimating lenses 92, 92a, and 92b in the light-emitting module 200 illustrated in FIGS. 1A to 1C and the light-emitting module 210 illustrated in FIG. 1D.

### Industrial Applicability

A light-emitting device according to the present disclosure may be particularly used for combining a plurality of laser beams to achieve high-power laser light. Further, the light-emitting device according to the present disclosure may be used for industrial fields requiring a high-power laser light source, such as cutting, drilling, local heat treatment, surface treatment, metal welding, and 3D printing of various materials.

### Reference Character List

10 Substrate
10us Mounting surface
10Ls Lower surface
20 Laser light source
21 Submount
21Ls Lower surface
21us Upper surface
22 Semiconductor laser element
22e Emission surface
23 Lens support member
23a Columnar portion
23as End surface
23b Link portion
24 Fast-axis collimating lens
30a First mirror member
30as First reflective surface
30b Second mirror member
30bs Second reflective surface
32 Resin layer
40 Frame body
40us1 First upper surface
40us2 Second upper surface
40Ls1 First lower surface
40Ls2 Second lower surface
40p Protruding portion
40w Wire
42a First conductive region
42b Second conductive region
42c Third conductive region
42d Fourth conductive region
44a First bonding region
44b Second bonding region
44c Third bonding region
46 Outer region
50 Cover
50us Upper surface
50Ls Lower surface
50t Light-transmitting region
52 Light-shielding film
60, 62 Support base
60-1, 62-1 First portion
60-2, 62-2 Second portion
60-3, 62-3 Third portion
60s1 First placement surface
60s2 Second placement surface
60s3 Third placement surface
70 Condensing lens
70a Fast-axis condensing lens
70b Slow-axis condensing lens
80 Optical fiber
80a Light-incident end
80b Light-emitting end
82 Support member
92 Slow-axis collimating lens
92a Slow-axis collimating lens
92b Slow-axis collimating lens
94, 94a, 94b, 94c Mirror member
94s, 94as, 94bs, 94cs Reflective surface
96 Half-wave plate
98 Polarizing beam splitter
100, 100-1, 100-2 Light-emitting device
200, 210 Light-emitting module
230 Optical multiplexer
250 Optical transmission fiber
300 Processing head
400 Object
1000 DDL device

## Claims

1. A light-emitting device comprising:
a substrate (10) having a mounting surface (10us);
a semiconductor laser element (22) supported by the mounting surface, the semiconductor laser element emitting a laser beam (L);
a first mirror member (30a) that is supported by the mounting surface and has a first reflective surface (30as) inclined with respect to the mounting surface and oriented obliquely upward;
a cover (50) that has a facing surface (50Ls) facing the mounting surface of the substrate, and an upper surface (50us) positioned on a side opposite to the facing surface and is positioned above the semiconductor laser element and the first mirror member;
a second mirror member (30b) that is supported by the upper surface of the cover and has a second reflective surface (30bs), at least a portion of the second reflective surface being positioned above at least a portion of the first reflective surface; and
a fast-axis collimating lens (24) that is positioned between the mounting surface of the substrate and the facing surface of the cover and is positioned on an optical path of the laser beam; wherein:
the semiconductor laser element is configured to emit the laser beam toward the first reflective surface;
the first reflective surface is configured to reflect the laser beam to change a traveling direction of the laser beam that has been emitted from the semiconductor laser element and passed through the fast-axis collimating lens to a direction away from the mounting surface of the substrate;
the cover is configured to transmit the laser beam reflected by the first reflective surface; and
the second reflective surface is configured to reflect the laser beam reflected by the first reflective surface to further change the traveling direction of the laser beam.

2. The light-emitting device according to claim 1, wherein a resin layer (32) is located between a lower surface of the second mirror member and the upper surface of the cover.

3. The light-emitting device according to claim 1 or 2, wherein the cover comprises a light-shielding film (52) on the facing surface of the cover, the light-shielding film positioned at least around a region (50t) through which the laser beam is transmitted.

4. The light-emitting device according to any of claims 1-3, wherein the substrate is formed of a material having a thermal conductivity in a range from 10 W/m•K to 2000 W/m•K.

5. The light-emitting device according to any of claims 1-4, further comprising:
a frame body (40) that is positioned around the mounting surface of the substrate and supports the cover, wherein
the semiconductor laser element is hermetically sealed by the substrate, the frame body, and the cover.

## Patentansprüche

1. Lichtemittierende Vorrichtung, umfassend:
ein Substrat (10) mit einer Montageoberfläche (10us);
ein durch die Montageoberfläche getragenes Halbleiterlaserelement (22), wobei das Halbleiterlaserelement einen Laserstrahl (L) emittiert;
ein erstes Spiegelbauteil (30a), das durch die Montageoberfläche getragen wird und eine erste reflektierende Oberfläche (30as) hat, die mit Bezug zu der Montageoberfläche geneigt und schräg nach oben orientiert ist;
eine Abdeckung (50), die eine zugewandte Oberfläche (50Ls) hat, die der Montageoberfläche des Substrats zugewandt ist, und eine obere Oberfläche (50us), die an einer Seite entgegengesetzt zu der zugewandten Oberfläche positioniert ist und über dem Halbleiterlaserelement und dem ersten Spiegelbauteil positioniert ist;
ein zweites Spiegelbauteil (30b), das durch die obere Oberfläche der Abdeckung getragen wird und eine zweite reflektierende Oberfläche (30bs) hat, wobei wenigstens ein Bereich der zweiten reflektierten Oberfläche über wenigstens einem Bereich der ersten reflektierenden Oberfläche positioniert ist; und
eine Schnelle-Achse-Kollimationslinse (24), die zwischen der Montageoberfläche des Substrats und der zugewandten Oberfläche der Abdeckung positioniert ist und auf einem optischen Pfad des Laserstrahls positioniert ist; wobei:
das Halbleiterlaserelement dazu konfiguriert ist, den Laserstrahl in Richtung der ersten reflektierenden Oberfläche zu emittieren;
die erste reflektierende Oberfläche dazu konfiguriert ist, den Laserstrahl zu reflektieren, um eine Ausbreitungsrichtung des Laserstrahls, der von dem Halbleiterlaserelement emittiert worden ist und durch die Schnelle-Achse-Kollimationslinse hindurchgegangen ist, zu einer Richtung weg von der Montageoberfläche des Substrats zu ändern;
wobei die Abdeckung dazu konfiguriert ist, den durch die erste reflektierende Oberfläche reflektierten Laserstrahl zu transmittieren; und
die zweite reflektierende Oberfläche dazu konfiguriert ist, den durch die erste reflektierende Oberfläche reflektierten Laserstrahl zu reflektieren, um die Ausbreitungsrichtung des Laserstrahls weiter zu ändern.

2. Lichtemittierende Vorrichtung nach Anspruch 1, wobei eine Harzschicht (32) zwischen einer unteren Oberfläche des zweiten Spiegelbauteils und der oberen Oberfläche der Abdeckung lokalisiert ist.

3. Lichtemittierende Vorrichtung nach Anspruch 1 oder 2, wobei die Abdeckung einen Lichtabschirmungsfilm (52) auf der zugewandten Oberfläche der Abdeckung umfasst, wobei der Lichtabschirmungsfilm wenigstens um eine Region (50t) herum positioniert ist, durch die der Laserstrahl transmittiert wird.

4. Lichtemittierende Vorrichtung nach einem der Ansprüche 1 bis 3, wobei das Substrat aus einem Material gebildet ist, das eine thermische Leitfähigkeit in einem Berich von 10 W/m × K bis 2000 W/m × K hat.

5. Lichtemittierende Vorrichtung nach einem der Ansprüche 1 bis 4, ferner umfassend:
eine Rahmenkörper (40), der um die Montageoberfläche des Substrats herum positioniert ist und die Abdeckung trägt, wobei
das Halbleiterlaserelement durch das Substrat, den Rahmenkörper und die Abdeckung hermetisch abgedichtet ist.

## Revendications

1. Dispositif électroluminescent comprenant :
un substrat (10) présentant une surface de montage (10us) ;
un élément laser à semi-conducteurs (22) supporté par la surface de montage, l'élément laser à semi-conducteurs émettant un faisceau laser (L) ;
un premier élément miroir (30a) qui est supporté par la surface de montage et présente une première surface réfléchissante (30as) inclinée par rapport à la surface de montage et orientée obliquement vers le haut ;
un couvercle (50) qui présente une surface en regard (50Ls) faisant face à la surface de montage du substrat, et une surface supérieure (50us) positionnée sur un côté opposé à la surface en regard et est positionnée au-dessus de l'élément laser à semi-conducteurs et du premier élément miroir ;
un deuxième élément miroir (30b) qui est supporté par la surface supérieure du couvercle et présente une deuxième surface réfléchissante (30bs), au moins une partie de la deuxième surface réfléchissante étant positionnée au-dessus d'au moins une partie de la première surface réfléchissante ; et
une lentille de collimation à axe rapide (24) qui est positionnée entre la surface de montage du substrat et la surface en regard du couvercle et est positionnée sur un trajet optique du faisceau laser ; dans lequel :
l'élément laser à semi-conducteurs est configuré pour émettre le faisceau laser vers la première surface réfléchissante ;
la première surface réfléchissante est configurée pour réfléchir le faisceau laser afin de changer une direction de parcours du faisceau laser, qui a été émis à partir de l'élément laser à semi-conducteurs et a traversé la lentille de collimation à axe rapide, dans une direction s'éloignant de la surface de montage du substrat ;
le couvercle est configuré pour transmettre le faisceau laser réfléchi par la première surface réfléchissante ; et
la deuxième surface réfléchissante est configurée pour réfléchir le faisceau laser réfléchi par la première surface réfléchissante pour changer encore la direction de parcours du faisceau laser.

2. Dispositif électroluminescent selon la revendication 1, dans lequel une couche de résine (32) est située entre une surface inférieure du deuxième élément miroir et la surface supérieure du couvercle.

3. Dispositif électroluminescent selon la revendication 1 ou 2, dans lequel le couvercle comprend un film de protection contre la lumière (52) sur la surface en regard du couvercle, le film de protection contre la lumière étant positionné au moins autour d'une région (50t) à travers laquelle le faisceau laser est transmis.

4. Dispositif électroluminescent selon l'une des revendications 1-3, dans lequel le substrat est formé d'un matériau présentant une conductivité thermique dans une plage allant de 10 W/m.K à 2000 W/m.K.

5. Dispositif électroluminescent selon l'une des revendications 1-4, comprenant en outre :
un corps de cadre (40) qui est positionné autour de la surface de montage du substrat et supporte le couvercle, dans lequel
l'élément laser à semi-conducteurs est hermétiquement scellé par le substrat, le corps de cadre et le couvercle.
